(19) Europäisches Patentamt
European Patent Office
Office européen des brevets

(11) **EP 3 614 162 B1**

(12) **EUROPÄISCHE PATENTSCHRIFT**

(45) Veröffentlichungstag und Bekanntmachung des Hinweises auf die Patenterteilung:
**03.08.2022   Patentblatt 2022/31**

(21) Anmeldenummer: **19191500.8**

(22) Anmeldetag: **13.08.2019**

(51) Internationale Patentklassifikation (IPC):
***G01R 33/383*** (2006.01)

(52) Gemeinsame Patentklassifikation (CPC):
**G01R 33/383;** H01F 7/0278

(54) **PERMANENTMAGNETANORDNUNG ZUR ERZEUGUNG EINES HOMOGENEN FELDES ("3D-HALBACH")**

PERMANENTLY MAGNETIZED ARRANGEMENT FOR PRODUCING A HOMOGENEOUS FIELD (3D HALBACH)

DISPOSITIF AIMANT PERMANENT PERMETTANT DE GÉNÉRER UN CHAMP HOMOGÈNE (« 3D HALBACH »)

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.08.2018   DE 102018214213**

(43) Veröffentlichungstag der Anmeldung:
**26.02.2020   Patentblatt 2020/09**

(73) Patentinhaber: **Bruker BioSpin GmbH**
**76287 Rheinstetten (DE)**

(72) Erfinder:
• **Niemann, Volker**
**75228 Ispringen (DE)**
• **Pietig, Rainer**
**76316 Malsch (DE)**

(74) Vertreter: **Kohler Schmid Möbus Patentanwälte Partnerschaftsgesellschaft mbB**
**Gropiusplatz 10**
**70563 Stuttgart (DE)**

(56) Entgegenhaltungen:
**JP-A- 2006 294 851     US-B2- 10 018 694**

**EP 3 614 162 B1**

**Beschreibung**

Die Erfindung betrifft eine Magnetresonanz-Apparatur mit einem Permanentmagnetsystem mit einer Magnetanordnung zur Erzeugung eines homogenen Magnetfeldes in Richtung senkrecht zu einer z-Achse in einem Messvolumen, wobei das Permanentmagnetsystem mindestens zwei koaxial um die z-Achse angeordnete, ringförmige Magnetelemente mit magnetischem Material in einer Ringebene umfasst, die in einer Halbach-Konfiguration einzelne Magnetsegmente aufweisen, wobei die Magnetisierungsrichtung von mindestens zwei ringförmigen Magnetelementen von der Ringebene derart abweicht, dass die zur Ringebene senkrechte Komponente mit dem Azimutalwinkel durch den Mittelpunkt des jeweiligen Magnetsegments eines ringförmigen Magnetelements variiert, wobei ein 3D-Winkel a die Abweichung der Magnetisierungsrichtungen von denen eines ebenen Halbachringes bestimmt, und wobei die Magnetisierung jeweils zweier ringförmiger Magnetelemente spiegelsymmetrisch zueinander ist, wobei die Spiegelebene die zur z-Achse senkrechte zentrale x-y-Ebene ist, wobei die ringförmigen Magnetelemente jeweils aus nebeneinander angeordneten Magnetsegmenten aus magnetischem Material aufgebaut sind, und wobei die Magnetisierungsrichtung der Magnetsegmente bezüglich ihrer zur jeweiligen Ringebene parallelen äußeren Oberflächen jeweils verschieden ist von derjenigen ihrer beiden im ringförmigen Magnetelement benachbarten Magnetsegmente.

Eine solche Magnetanordnung ist bekannt aus der JP 2006 294851 A (=Referenz [1a]) oder der US 10 018 694 B2 (=Referenz [1b]).

Hintergrund der Erfindung

Die vorliegende Erfindung betrifft allgemein den Bereich des Magnetbaus, insbesondere der Herstellung und des Betriebs von Magnetanordnungen. Des Weiteren befasst sich die Erfindung aber auch mit dem Gebiet der Magnetresonanz (MR), insbesondere die Bereitstellung von hierfür geeigneten Permanentmagnetsystemen, die zur Erzeugung von homogenen Magnetfeldern für NMR-Messungen bestimmt sind.

Sowohl im Bereich der Kernresonanzspektroskopie (NMR) als auch bei der bildgebenden Anwendung (MRI) wird in einem zu definierenden Probenvolumen ein sehr homogenes und zeitlich konstantes Magnetfeld benötigt, welches mit resistiven oder supraleitenden Spulen oder einer geeigneten Permanentmagnetanordnung erzeugt werden kann. Die Verwendung von Permanentmagneten wird bevorzugt, wenn Flussdichten von unterhalb 2T ausreichend sind und ein vergleichsweise kompakter Aufbau erwünscht ist.

Benchtop-NMR-Geräte benötigen ein hochgradig homogenes Magnetfeld, welches etwa mit einer supraleitenden Magnetspulenanordnung, aber auch mit einer Permanentmagnetanordnung erzeugt werden kann.

Das Halbach-Design ist eine bekannte Anordnung, welche für diesen Zweck verwendet werden kann. Die Verwendung von ringförmigen Permanentmagneten mit einer Magnetisierung als Halbach-Dipol ist im Stand der Technik beschrieben (siehe etwa Referenz [2]).

In der Theorie kann mit diesen Magnetanordnungen auch die für NMR Messungen erforderliche hohe Feld-Homogenität erzielt werden, jedoch ist es gerade bei Magnetringen in Halbachkonfiguration recht schwierig, ein derart homogenes B0 Feld zu erzeugen. Typischerweise werden ringförmige Halbach-Dipole derart aufgebaut, dass einzelne Magnetsegmente mit variierenden Magnetisierungsrichtungen aneinandergefügt werden, wobei sich die Magnetisierungsrichtung mit dem Azimutwinkel verändert. Um die für NMR-Messungen geforderte Feldhomogenität im Probenvolumen zu erreichen, müssen bei den jochfreien Halbach-Magneten Korrekturmechanismen vorgesehen werden, um Toleranzen des Magnetmaterials oder der Position der einzelnen Magnetblöcke ausgleichen zu können, was den mechanischen Aufbau verkompliziert. Jochbasierte Magnete besitzen in der Regel ein paralleles Polschuhpaar aus einem weichmagnetischen Werkstoff mit entsprechend hoher Sättigungsflussdichte. Durch geeignete Wahl der Polschuhgeometrie und spezielle Oberflächenbearbeitung kann das Feldprofil auf vergleichsweise einfache und effiziente Weise optimiert werden. Die Hauptursachen, die der Feldhomogenität entgegenstehen kann man wie folgt zusammenfassen:

1. Endlichkeit der Anordnung in axialer Richtung, also prinzipielle Abweichung von einem in axialer Richtung unendlich ausgedehnten Zylinder.
2. Diskretisierung der Magnetisierungsrichtung entlang des Zylinderumfangs, also prinzipielle Abweichung von der kontinuierlich mit dem Azimutwinkel variierenden Magnetisierungsrichtung.
3. Zusätzliche Störungen durch mechanische Toleranzen bei Größe, Positionierung und magnetischem Moment der Magnetsegmente.

Spezieller Stand der Technik

Die US 4,837,542 A (=Referenz [3]) offenbart einen kugelförmigen Permanentmagneten, der aus Einzelsegmenten aufgebaut ist, wobei die Segmente keilförmig zum Mittelpunkt verjüngt sind und zu den Polbereichen hin kleiner werden (Kugelsegmente). Der Aufbau einer solchen Halbachkugel ist recht aufwändig, ein Aufbau aus ebenen Ringen mit geometrisch identischen Segmente ist *nicht* offenbart. Die Magnetisierungsrichtung der Einzelsegmente im Umlauf um die Kugel ist in klassischer Halbachkonfiguration ($\alpha=2\theta$). Die zentrale Bohrung des Magneten verläuft longitudinal entlang der Polarachse in Richtung des B0 Feldes. Bei ebenen, aus segmentierten Ringen aufgebauten Halbachmagneten verläuft die Bohrung transversal, also senkrecht zur Richtung des Zentralfeldes. Bei einer longitudinalen Bohrung ist das B0 Feld geringer und somit weniger effektiv. Außerdem erzeugt der Grundmagnet nach Referenz [3] im Allgemeinen ein inhomogenes Magnetfeld.

Die US 2015/0061680 A1 (=Referenz [4]) beschreibt Magnetanordnungen und Verfahren zum Erzeugen von Magnetfeldern. Sie umfasst Magnetanordnungen mit einer Mehrzahl von polyedrischen Magneten, die in einer Gitterkonfiguration angeordnet sind und zumindest teilweise ein Testvolumen umschließen, wobei die Magnetanordnung ein zugeordnetes Magnetfeld mit einer bestimmten Feldrichtung aufweist. Die Magnetisierungsrichtung der einzelnen Polyedermagneten und deren Anordnung ist dergestalt, dass das entstehende magnetische Feld eine Halbachkugel approximiert. Es werden also Anordnungen beschrieben, bei denen die Magnetisierungsrichtungen denjenigen des dreidimensionalen Halbach-Designs entsprechen. Zylindrische Ringe werden allerdings nicht erwähnt, es werden lediglich die polyedrischen Magnetsegmente aneinandergefügt. Außerdem ist das Feld des Grundmagneten nach dem hier beschriebenen Verfahren im Allgemeinen nicht homogen und somit für MR-Anwendungen ungeeignet.

Das einfache Halbach-Design benötigt eine große axiale Länge und damit eine große Menge an Magnetmaterial, um ein Feld mit ausreichender Homogenität zu erzeugen. Auch ein ebenes Halbach-Design mit Nuten (="Notches") benötigt noch unnötig viel Magnetmaterial, da die axial weit entfernten Teile des Magneten eine ungünstige Magnetisierungsrichtung hinsichtlich ihres Feldbeitrages am Probenort besitzen.

In der US 2010/013473 A1 (=Referenz [2]) wird ein NMR Permanentmagnet vorgeschlagen mit einer Halbach Architektur aus drei Ringen, wobei ein zentraler Magnetring von zwei Kopfringen flankiert wird. Die Ringe sind zum Zwecke der Feldhomogenisierung gegenseitig in Längsrichtung mittels Schrauben oder Gewindemuttern verschiebbar. In diesem Dokument ist weiterhin offenbart, dass die Ringe aus Einzelsegmenten bestehen, die abwechselnd trapezförmig und rechteckig sind, wobei die einzelnen Segmente zur Feldhomogenisierung in Radialrichtung verschiebbar sind. Dieser Magnet hat 64 mechanische Freiheitsgrade. Diese einzustellen ist in jedem Fall ziemlich aufwändig. Die Magnetisierung der Einzelsegmente variiert immer nur in Azimutalrichtung und hat keinen Winkelanteil, der aus der Ebene der jeweiligen Magnetringe herauszeigt.

Die eingangs zitierte US 10 018 694 B2 (=Referenz [1b]) beschreibt eine Magnetresonanz-Apparatur mit einem Permanentmagnetsystem. Quaderförmige Magnete sind zur Erzeugung eines homogenen Magnetfeldes in einem Messvolumen ringförmig auf dem Gehäuse der Magnetresonanz-Apparatur angeordnet. Die halbachartige Orientierung der Magnetisierungen bezüglich des Messvolumens wird dabei durch eine wechselnde Orientierung der jeweiligen Magnete im Gehäuse erreicht. Die quaderförmigen Magnete sind hinsichtlich ihrer Oberflächen einheitlich magnetisiert. Diese Magnetresonanz-Apparatur hat den Nachteil, dass sie aufwendig zu erstellen ist, da die Ausprägung der Halteaufnahmen im Gehäuse für die einzelnen Magnete sehr präzise zur Orientierung gemäß der Halbach-Bedingung erfolgen muss. Zudem wird durch den räumlichen Abstand der Magnete zum Messvolumen bezüglich der erreichbaren Magnetfeldstärke eine geringe Effizienz erreicht. Aufgrund der Quaderform der einzelnen Magnete ist eine kompakte Bauform auch nicht möglich.

### Aufgabe der Erfindung

Der vorliegenden Erfindung liegt demgegenüber die Aufgabe zugrunde, mit einfachen technischen Maßnahmen und ohne Volumenzunahme eine möglichst kompakte und leichtgewichtige Permanentmagnetanordnung der eingangs definierten Art für eine MR-Vorrichtung bereitzustellen, die -bei vorgegebener Feldstärke- zumindest in den meisten Bereichen des Magneten eine hinsichtlich ihres Feldbeitrages am Probenort günstige Magnetisierungsrichtung aufweist und dort gleichzeitig einen Bereich mit besonders homogener Feldverteilung sowie -insbesondere bei hohen Feldstärken- ein möglichst geringes Streufeld erzeugt.

### Kurze Beschreibung der Erfindung

Diese Aufgabe wird durch die vorliegende Erfindung auf ebenso überraschend einfache wie wirkungsvolle Weise dadurch gelöst, dass eine Magnetresonanz-Apparatur mit einem Permanentmagnetsystem mit einer Magnetanordnung bereitgestellt wird, wie sie in Anspruch 1 definiert wird. Die Magnetanordnung weist Magnetsegmente auf, die so aufgebaut sind, dass die Magnetisierungsrichtung der einzelnen Magnetsegmente der Formel

$$Mr=MCos[\alpha]Cos[\phi 0], \quad M\phi=MSin[\phi 0], \quad Mz=MCos[\phi 0]Sin[\alpha]$$

folgt, wobei Mr, M$\phi$ und Mz die Komponenten des Magnetisierungsvektors in Zylinderkoordinaten bezeichnen, M die Remanenz des im jeweiligen ringförmigen Magnetelement verwendeten Magnetmaterials bezeichnet, $\phi 0$ den Azimutalwinkel durch den Mittelpunkt des jeweiligen Magnetsegments bezeichnet und a einen für das gesamte ringförmige Magnetelement festen Parameter bezeichnet, nämlich den 3D-Winkel, der die Abweichung der Magnetisierungsrichtungen von denen eines ebenen Halbachringes bestimmt. Die Erfindung beinhaltet Anordnungen von dreidimensionalen Halbachringen mit dem Ziel ein möglichst starkes homogenes Magnetfeld in einem vordefinierten Probenvolumen bei möglichst geringem Materialeinsatz zu erzeugen. Ein dreidimensionaler (3D) Halbachring entsteht aus einem klassischen ebenen Halbachring durch Rotation der Magnetisierungsvektoren um die Richtung des Azimutalvektors um einen 3D-Winkel $\alpha$, einen für den gesamten Magnetring festen Parameter. Diese Ringe werden so angeordnet, dass die Magnetisierungsrichtungen fast im gesamten Magnetsystem günstig für eine Verstärkung des Hauptfeldes ausgerichtet sind. Lediglich in kleinen probennahen Bereichen werden größere Abweichungen von dieser günstigen Ausrichtung der Magnetisierung zugelassen, um die Homogenität des Feldes im Probenvolumen zu verbessern.

Zentraler Vorteil der erfindungsgemäßen Anordnungen von dreidimensionalen Halbachringen ist, dass die Magnetfeldstärke im Vergleich zu ebenen Halbachringen höher ist bei gleichem Materialeinsatz. Betrachtet man beispielsweise einen in axialer Richtung unendlich ausgedehnten ebenen Halbach-Magneten, so ergibt sich ein Magnetfeld B0 von $Br*log(r_a/r_i)$, wobei Br die Remanenz des Magnetmaterials, $r_a$ der Außenradius und $r_i$ der Innenradius des Magnetrings ist, und für den optimierten 3D-Halbach ($\alpha$ = 2*Polarwinkel- $\pi$) ein B0 von $4/3*Br*log(r_a/r_i)$, wobei der Polarwinkel der Winkel zwischen dem Ortsvektor des jeweils betrachteten Magnetelementes und der Bohrungsachse ist. Der 3D-Halbach ist also bei gleichem Materialeinsatz potentiell um einen Faktor 4/3 stärker als der ebene Halbach.

Ein Permanentmagnetsystem gemäß der vorliegenden Erfindung umfasst zwei oder mehr dreidimensionale Halbachringe mit gemeinsamer Achse. Ein dreidimensionaler Halbachring ist dabei ein Ring aus hartmagnetischem Material mit rechteckigem Querschnitt.

Die Dimensionen der Ringe, ihre relativen Positionen zueinander und ihre 3D-Winkel werden so gewählt, dass die On-axis- (zonalen) Feldordnungen bis zu einer vorgegebenen Ordnung, der "Design-Ordnung", verschwinden und gleichzeitig der Wert des Zentralfeldes maximiert wird. Die Off-axis-(tesseralen) Feldordnungen verschwinden dann ebenfalls bis zur vorgegebenen Ordnung.

Bei Halbachringen (egal ob eben oder 3D-Halbach) treten grundsätzlich nur zonale und doppeltperiodische (tesserale) Feldordnungen auf. Zwischen den zonalen (=on-axis) und doppeltperiodischen also tesseralen (=off-Axis) Termen gleicher Ordnung n besteht darüber hinaus eine proportionale Beziehung, wobei der Proportionalitätsfaktor von n abhängt. Eine Anordnung aus Halbachringen, die so gestaltet wurde, dass ein bestimmter zonaler Term verschwindet, hat also auch keine tesseralen Terme in dieser Ordnung. Beide Eigenschaften (grundsätzlich nur doppeltperiodische Terme und proportionale Beziehung zwischen zonalen und doppeltperiodischen Termen) wurden für ebene Halbachringe aus den Maxwell-Gleichungen abgeleitet und für 3D-Halbachringe überprüft, was bisher nicht allgemein bekannt war.

Die verbleibenden Inhomogenitäten mit Ordnungen kleiner oder gleich der Design-Ordnung sind dann auf mechanische Toleranzen und Material-Inhomogenitäten zurückzuführen und können mit bekannten Shim-Technologien korrigiert werden.

Jeder dreidimensionale Halbachring besteht aus einheitlichem Permanentmagnetmaterial. Das Material verschiedener Ringe kann sich dabei unterscheiden.

Bevorzugte Ausführungsformen und Weiterbildungen der Erfindung

Wie bereits oben ausgeführt, erfolgt die Anordnung der Magnetsegmente erfindungsgemäß so, dass die Magnetisierungsrichtung der einzelnen Magnetsegmente der Formel

$$Mr = MCos[\alpha]Cos[\phi 0], \quad M\phi = MSin[\phi 0], \quad Mz = MCos[\phi 0]Sin[\alpha]$$

folgt, wobei Mr, $M\varphi$ und Mz die Komponenten des Magnetisierungsvektors in

Zylinderkoordinaten bezeichnen, M die Remanenz des im jeweiligen ringförmigen Magnetelement verwendeten Magnetmaterials bezeichnet, den Azimutalwinkel durch den Mittelpunkt des jeweiligen Magnetsegments bezeichnet und a einen für das gesamte ringförmige Magnetelement festen Parameter bezeichnet, nämlich den 3D-Winkel, der die Abweichung der Magnetisierungsrichtungen von denen eines ebenen Halbachringes bestimmt. Bei geeigneter Wahl der Ringmaße, der Ringpositionen und der 3D-Winkel ergibt sich eine Annäherung an eine 3D-Halbach-Anordnung wie in Referenz [3], allerdings mit transversaler Bohrung, also einer Bohrung senkrecht zur Feldrichtung. Diese Anordnung ist effektiver als ein longitudinal gebohrter 3D-Halbach mit Bohrung in Feldrichtung, erzeugt also bei gleichem Magnetmaterial-Einsatz mehr Feld.

Weitere vorteilhafte Ausführungsformen sind dadurch gekennzeichnet, dass die Magnetsegmente aus einem hartmagnetischen Material mit einer hohen Remanenz M, wobei 1,5T > M > 0,7T, und mit kleiner Permeabilität $\mu$ im Bereich 1,0 < $\mu$ < 1,5, insbesondere aus NdFeB, hergestellt sind. Damit können hohe Feldstärke bei kleinem Gewicht erreicht werden und die wechselseitige Beeinflussung der Magnetteile bleibt klein.

Eine weitere vorteilhafte Ausführungsform sieht vor, dass die in einem Bereich hoher Feldstärken angeordneten Magnetsegmente aus einem hochkoerzitiven Material mit einer Koerzitivität HcJ im Bereich 2800kA/m > HcJ > 1500kA/m hergestellt sind. Dadurch wird die Gefahr einer partiellen Entmagnetisierung deutlich verringert.

Eine bevorzugte Ausführungsform der Erfindung ist dadurch gekennzeichnet, dass die Magnetsegmente aus einem Temperatur-kompensierten Permanentmagnet-Material mit einem Temperaturkoeffizienten Tk im Bereich 0%/K > Tk > -0,05%/K, insbesondere aus SmCo, hergestellt sind. Der Magnet wird auf diese Weise temperaturstabiler und der zur Temperierung erforderliche Aufwand verringert sich.

Eine Klasse von besonders bevorzugten Ausführungsformen der erfindungsgemäßen Magnetanordnung zeichnet sich dadurch aus, dass neben den spiegelsymmetrischen 3D-Halbachringen eines oder mehrere der ringförmigen Magnetelemente als ebener Halbach-Ring mit $\alpha = 0$ aufgebaut ist/sind. Die zusätzlichen ebenen Halbachringe dienen hauptsächlich der weiteren Verstärkung des B0 Feldes. Vorzugsweise ist dies ein zentraler Ring, der von zwei spiegelsymmetrischen 3D Halbachringen umgeben ist. Vorteil ist vor allem, dass im zentralen probennahen Bereich keine Grenzflächen auftreten, die immer mit Ungenauigkeiten und damit mit Störungen der Homogenität verbunden sind. Es ist aber auch denkbar, dass die 3D Halbachringe von ebenen Halbach-Ringen mit $\alpha = 0$ flankiert sind.

Bei einer Klasse von ergänzenden oder alternativen Ausführungsformen ist/sind neben den spiegelsymmetrischen 3D-Halbachringen eines oder mehrere der ringförmigen Magnetelemente als lateral homogen magnetisierter Ring mit $\alpha = \pi$ aufgebaut. Ein lateral homogen magnetisierter Ring kann wie ein beliebiger dreidimensionaler Halbachring aus Segmenten aufgebaut werden. Wegen der einheitlichen Magnetisierungsrichtung besteht aber auch die Möglichkeit, ihn aus einem durchgängigen Rohr zu fertigen, das anschließend am Stück aufmagnetisiert wird. Diese lateral homogen magnetisierten Ringe mit $\alpha = \pi$ sind vorzugsweise in Bereichen nahe der Bohrung, also konzentrisch innenliegend angeordnet.

In beiden Klassen von Ausführungsformen lässt sich die Anordnung besonders einfach herstellen, es existieren weniger voneinander verschiedene Arten von Segmenten und damit ergibt sich auch eine höhere Symmetrie.

Besonders vorteilhaft sind auch Ausführungsformen der Erfindung, die sich dadurch auszeichnen, dass die ringförmigen Magnetelemente so aufgebaut sind, dass Fernfeldkoeffizienten niedriger Ordnung $n \leq 6$, insbesondere das Dipolmoment, verschwinden. Damit lässt sich das Streufeld der Magnetanordnung im Betrieb erheblich verringern.

In der Praxis bewähren sich auch Ausführungsformen, die dadurch gekennzeichnet sind, dass die ringförmigen Magnetelemente konzentrisch um die z-Achse angeordnet sind, und dass das radial innere ringförmige Magnetelement eine höhere Koerzitivfeldstärke aufweist als die radial äußeren ringförmigen Magnetelemente. Dies ist insbesondere dann sinnvoll, wenn mehr als zwei Ringe vorhanden sind, die paarweise konzentrisch aufgebaut sind und die Magnetpaarringe koaxial zueinander angeordnet sind. Die Gefahr einer partiellen Entmagnetisierung wird dadurch verringert.

Bei besonders einfach und preisgünstig herstellbaren Ausführungsformen weisen die Magnetsegmente jedes ringförmigen Magnetelements die gleiche äußere Form auf.

Aus geometrischen Gründen sind Ausführungsformen der Erfindung vorteilhaft, bei denen Magnetsegmente jedes ringförmigen Magnetelements die Form eines trapezoidalen Prismas aufweisen. Solche trapezoidalen Prismen lassen sich besonders einfach zu einem in etwa hohlzylindrischen Kreisring zusammenfügen.

Besonders hohe Magnetfeldstärken beziehungsweise eine besondere Kompaktheit der Anordnung lassen sich mit Ausführungsformen erzielen, bei welchen die Magnetsegmente jedes ringförmigen Magnetelements im montierten Zustand unmittelbar aneinander angrenzend angeordnet sind.

Innerhalb jedes ringförmigen Magnetelementes bestehen die Magnetsegmente aus einheitlichem Permanentmagnetmaterial. Die Magnetsegmente sind innerhalb der ringförmigen Magnetelemente bevorzugt unmittelbar benachbart, insbesondere sind die Lücken zwischen den Magnetsegmenten wesentlich kleiner als die äußeren Abmessungen der Magnetsegmente. Zur Stabilisierung der ringförmigen Magnetelemente werden die Lücken vorteilhaft mit einem Klebstoff gefüllt.

Darüber hinaus sind die Magnetsegmente vorteilhafter Weise innerhalb der Magnetelemente bezüglich der z-Achse symmetrisch angeordnet, d.h. eine Rotation des ringförmigen Magnetelementes um den Winkelbereich eines Magnetsegmentes bezüglich der z-Achse überführt die Struktur, aber nicht unbedingt die Magnetisierungsrichtung, des ringförmigen Magnetelementes in sich selber. Weiterhin variiert die Magnetisierungsrichtung benachbarter Magnetsegmente in den ringförmigen Magnetelementen, ebenfalls gegenüber der äußeren Form der Magnetsegmente. Vor der Assemblierung der Magnetsegmente zu ringförmigen Magnetelementen müssen benachbarte Magnetsegmente individuell in einer bezüglich ihrer äußeren Form verschiedenen Richtung magnetisiert werden, wobei die Richtung unter Einhaltung des 3D-Winkels a sowie des Halbachwinkels gewählt wird. Magnetmaterialien haben oft eine Vorzugsachse entlang derer eine Magnetisierung besonders effektiv erfolgen kann. Daher ist es vorteilhaft, wenn die einzelnen Magnetsegmente individuell so aus dem Magnetmaterial geformt werden, dass diese Vorzugsachse in Richtung der vorzunehmenden Magnetisierungsrichtung für die Anordnung im ringförmigen Magnetelement verläuft.

In der Regel werden die ringförmigen Magnetelemente in z-Richtung übereinander gestapelt angeordnet sein, wobei das Permanentmagnetsystem mindestens zwei ringförmige Magnetelemente aufweist und die ringförmigen Magnetelemente als Ganzes fest verklebt und als Ganzes lateral gegeneinander verschiebbar sind. Diese Anordnung ermöglicht eine Montage der einzelnen Ringbaugruppen (gegebenenfalls aus unterschiedlichen Materialien) als in sich geschlossene Baugruppen im Gegensatz zur Halbachkugel gemäß Referenz [3].

Besonders bevorzugt ist eine Ausführungsform der erfindungsgemäßen Magnetanordnung, bei der die ringförmigen Magnetelemente um die z-Achse verdrehbar gelagert sind. Herstellungsbedingte Schwankungen der ringförmig zusammengesetzten Segmente können eine Winkelabweichung der magnetischen Achse eines gesamten Rings hervorrufen. Durch die beschriebene Ausführungsform, kann diese Winkelabweichung mittels Einstellen eines entsprechenden Winkels im Gegensinn korrigiert werden.

Ganz besonders bevorzugt sind Ausführungsformen der Erfindung, bei denen eine Einrichtung zur Homogenisierung des Magnetfelds, vorzugsweise ein Shim-Rohr, zum Shimmen der höheren Feldordnungen vorhanden ist. Die im Vorfeld beschriebenen Mechanismen werden auf diese Weise durch ein weiteres noch präziseres Instrument zur Homogenisierung ergänzt. Damit sind noch feiner auflösende Korrekturen möglich.

Durch passive Shimelemente kann die Homogenität im Inneren der Magnetbohrung, insbesondere in einem Shimrohr deutlich verbessert werden. Außerdem kann auch eine Verbesserung der Homogenität durch elektrische Shimspulen im Inneren der Bohrung erreicht werden.

In den Rahmen der vorliegenden Erfindung fällt auch ein Verfahren zur Herstellung einer Magnetresonanz-Apparatur mit einem Permanentmagnetsystem mit einer Magnetanordnung, wie sie in Anspruch 12 definiert wird. Das Verfahren umfasst die folgenden

a) Vorgeben eines Ziel-Magnetfeldes B0 sowie der erforderlichen Anzahl an Magnetringen aus bekanntem Magnetmaterial und einem gewünschten Innendurchmesser der zentralen Bohrung;

b) Bestimmen der gewünschten Homogenität und Streufeldeigenschaften durch Nullsetzen mindestens einer Feldordnung der zentralen oder der Fernfeld-Entwicklung;

c) Bestimmen der freien Designparameter, nämlich Geometrieparameter der Ringe und 3D-Winkel a der Ringe, durch Optimierung des Magnetvolumens unter den Nebenbedingungen der Schritte a) und b);

d) Bestimmen des gewünschten Gewichts als Funktion der unter Schritt c) bestimmten Designparameter;

e) Aufbau der Magnetsegmente der Magnetanordnung, so dass die Magnetisierungsrichtung der einzelnen Magnetsegmente der Formel $Mr = M\cos[\alpha]\cos[\Phi 0]$, $M\Phi = M\sin[\Phi 0]$ $Mz = M\cos[\Phi 0]\sin[\alpha]$ folgt, wobei Mr, MΦ und Mz die Komponenten des Magnetisierungsvektors in Zylinderkoordinaten bezeichnen, M die Remanenz des im jeweiligen ringförmigen Magnetelement verwendeten Magnetmaterials bezeichnet, Φ0 den Azimutalwinkel des Segmentmittelpunktes und $\alpha$ den für das gesamte ringförmige Magnetelement festen 3D-Winkel bezeichnet, der die Abweichung der Magnetisierungsrichtungen von denen eines ebenen Halbachringes bestimmt.

Bei einer vorteilhaften Variante des erfindungsgemäßen Verfahrens erfolgt in Schritt c) die Berechnung der Feldordnungen und des Magnetvolumens direkt aus den Designparametern über analytische Formeln. Auf diese Weise läuft die Optimierungsrechnung besonders schnell und umfangreiche Parameterstudien werden ermöglicht.

In einer weiteren bevorzugten Verfahrensvariante werden die einzelnen Magnetsegmente in der definierten Magnetisierungsrichtung unter Einhaltung des 3D-Winkels a sowie des Halbachwinkels hergestellt, bevor sie zu Magnetringen assembliert werden. Die Segmente haben die vorgegebenen Dimensionen wie sie in Schritt a) vorgegeben sind und in den Schritten c) und d) bestimmt wurden. Die Anzahl der Segmente pro Ring liegt vorzugsweise zwischen 8 und 32, besonders bevorzugt von 16 bis 24. Die Anzahl der Segmente pro Ring ist entscheidend für die Off-axis-Homogenität. Eine höhere Segmentzahl bewirkt außerdem eine größere Annäherung an die Design-Feldstärke.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden, sofern die dadurch erreichte Merkmalskombination in den durch die Ansprüche definierten Schutzumfang der Erfindung fällt. Die gezeigten und beschriebenen Ausführungsformen sind nicht als abschließende Aufzählung zu verstehen, sondern haben vielmehr beispielhaften Charakter für die Schilderung der Erfindung.

Detaillierte Beschreibung der Erfindung und Zeichnung

Die Erfindung ist in den Figuren und Diagrammen der Zeichnung dargestellt und wird anhand von Ausführungsbeispielen näher erläutert.

Es zeigen:

Fig.1a     eine schematische räumliche Vertikalschnitt-Halbdarstellung einer einfachen Ausführungsform der erfindungsgemäßen Magnetanordnung mit zwei bezüglich der xy-Ebene spiegelsymmetrisch angeordneten ringförmigen Magnetelementen sowie jeweils durch Pfeile angedeuteter 3D-Halbach-Magnetisierung der einzelnen Magnetsegmente;

Fig. 1b eine schematische räumliche Darstellung eines vollständigen erfindungsgemäßen ringförmigen Magnetelements mit eingezeichnetem Azimutalwinkel $\phi$ und 3D-Winkel a;

Fig.2a eine schematische räumliche Darstellung der mit Pfeilen für die jeweilige Magnetisierungsrichtung visualisierten erfindungsgemäßen räumlichen 3D-Halbachkonfiguration;

Fig.2b wie Fig. 2a, jedoch mit flacher 2D-Halbachkonfiguration in einer Ringebene nach dem Stand der Technik;

Fig.3a eine schematische Schnittdarstellung durch eine Ringebene einer Magnetanordnung mit flacher 2D-Halbachkonfiguration der lokalen Magnetisierungsrichtungen nach dem Stand der Technik;

Fig.3b die Magnetanordnung nach dem Stand der Technik aus Fig.3a im schematischen Vertikalschnitt;

Fig.4a eine räumliche Skizze des Zusammenhangs der Designvariablen "Außenradius", "3D-Winkel" und "halbe Länge" für die optimierte Auslegung einer erfindungsgemäßen Magnetanordnung;

Fig. 4b eine räumliche Skizze der Funktion des Parameters "Gewicht" in Abhängigkeit von den Designvariablen "Außenradius" und "halbe Länge" für die optimierte Auslegung einer erfindungsgemäßen Magnetanordnung;

Fig.5 einen schematischen Vertikal-Schnitt durch eine einfache Ausführungsform der Erfindung mit zwei 3D-Halbachringen in spiegelsymmetrischer Anordnung (=Ausführungsbeispiel 1);

Fig. 6 einen schematischen Vertikal-Schnitt durch eine weitere Ausführungsform der Erfindung mit drei Halbachringen, wobei der mittlere Ring einen 3D-Winkel von $\alpha=0$ aufweist, während die beiden äußeren Ringe in spiegelsymmetrischer Anordnung zueinander stehen (=Ausführungsbeispiel 2); und

Fig. 7 eine noch komplexere Ausführungsform der erfindungsgemäßen Magnetanordnung mit acht Magnetringen (=Ausführungsbeispiel 3).

Die erfindungsgemäße **Magnetanordnung 1**, wie sie in der Zeichnung in verschiedenen Ausführungsformen jeweils schematisch dargestellt ist, ist

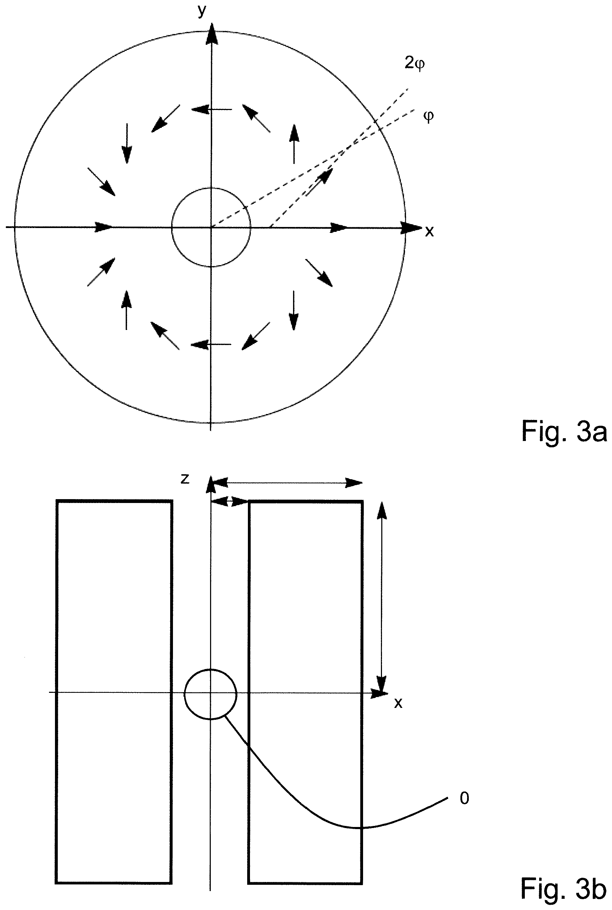

Bestandteil einer -in der Zeichnung nicht eigens gezeigten- Magnetresonanz-Apparatur mit einem Permanentmagnetsystem zur Erzeugung eines homogenen Magnetfeldes in Richtung einer z-Achse in einem (in Fig. 3b angedeuteten) **Messvolumen 0**, wobei das Permanentmagnetsystem mindestens zwei koaxial um die z-Achse angeordnete, **ringförmige Magnetelemente 2, 2'** aus magnetischem Material in einer Ringebene umfasst, die in einer Halbach-Konfiguration aus einzelnen, nebeneinander angeordneten **Magnetsegmenten 3** aufgebaut sind.

Eine "klassische" Halbach-Konfiguration, wie sie auch schon im Stand der Technik beschrieben wird, ist in den Figuren 3a und 3b schematisch dargestellt:

**Fig. 3a** zeigt einen Schnitt durch eine Ringebene einer solchen Magnetanordnung mit flacher (2D) Halbachkonfiguration der lokalen Magnetisierungsrichtungen von jeweils 2 $\phi$ an einer Stelle mit Azimutalwinkel $\phi$.

**Fig.3b** zeigt die Magnetanordnung aus Fig.3a im schematischen Vertikalschnitt.

Die vorliegende Erfindung betrifft zwar ebenfalls ein Magnetringsystem aus mehreren Ringen in Halbachkonfiguration, wobei jedoch die äußeren Ringe in der Magnetisierungsrichtung eine Raumkomponente (3D) umfassen, die aus der Ringebene herausweist. Als wesentlichen Nutzeffekt ermöglicht diese Anordnung eine kompaktere Bauart des Magneten bei höherer Feldstärke sowie auch ein geringeres Streufeld.

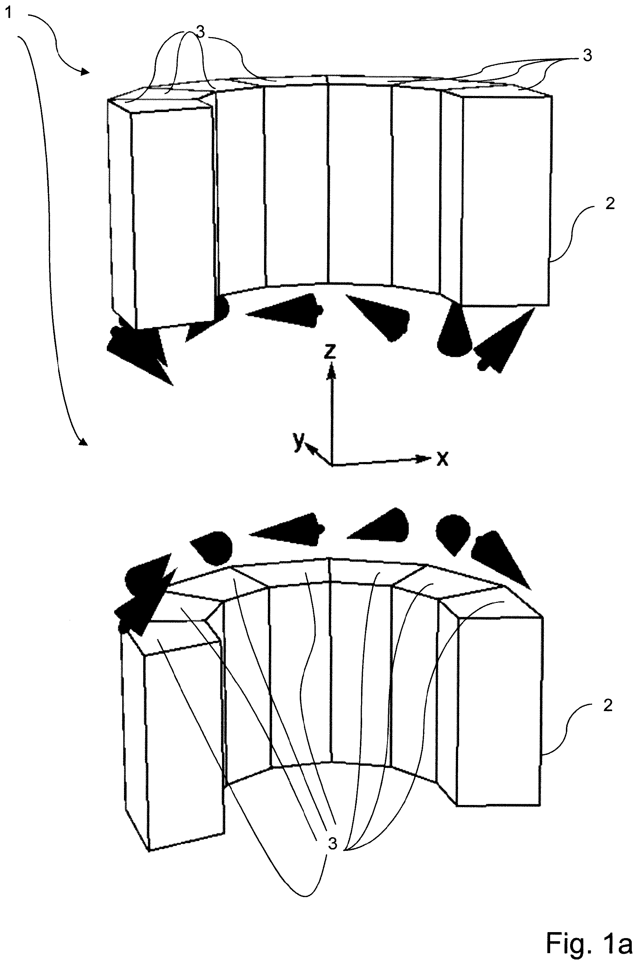

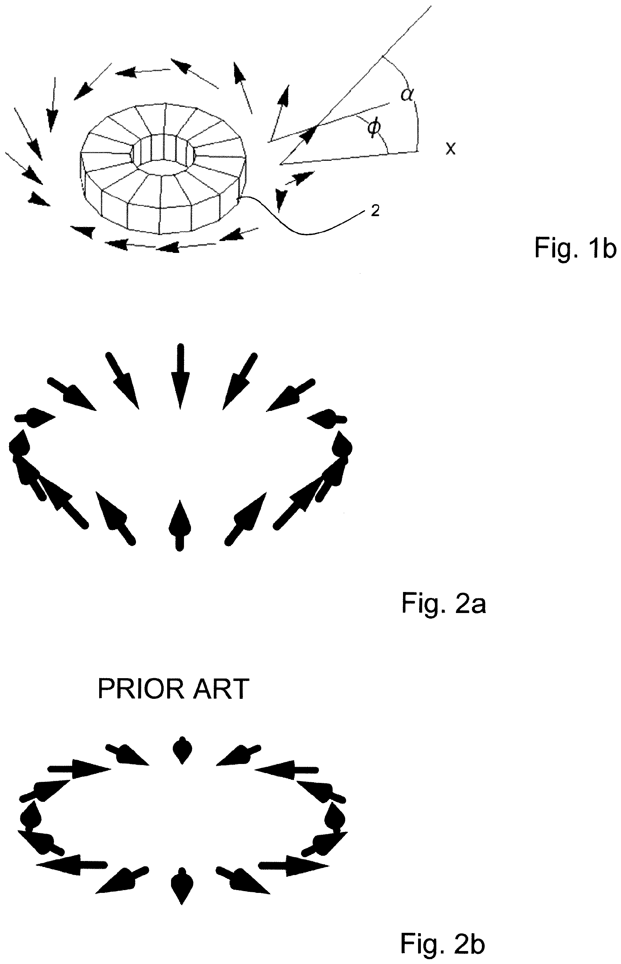

Generell zeichnet sich die Magnetanordnung 1 gemäß der vorliegenden Erfindung -wie sie anschaulich in den **Figuren 1a und 1b** gezeigt ist- dadurch aus, dass die Magnetisierungsrichtung von mindestens zwei ringförmigen Magnetelementen 2, 2' von der Ringebene derart abweicht, dass die zur Ringebene senkrechte Komponente Kosinusförmig mit dem Azimutalwinkel des jeweiligen ringförmigen Magnetelements 2, 2' variiert, wobei ein **3D-Winkel** $\alpha$ die Abweichung der Magnetisierungsrichtungen von denen eines ebenen (2D) Halbachringes bestimmt, und dass die Magnetisierung jeweils zweier ringförmiger Magnetelemente 2, 2' spiegelsymmetrisch zueinander ist, wobei die Spiegelebene die zur z-Achse senkrechte zentrale x-y-Ebene ist.

In Fig. 1b ist der **3D-Winkel** $\alpha$ als Winkel zwischen der x-Achse und der Magnetisierungsrichtung desjenigen Segmentes, welches in x-Richtung positioniert ist, eingezeichnet.

Eine 3-dimensionale Verteilung der Magnetisierungsrichtungen in einem 3D-Halbach-Ring, bei welcher die Magnetisierungsvektoren erfindungsgemäß teilweise aus der Ringebene herausragen, ist in **Fig. 2a** dargestellt.

Zum Vergleich zeigt **Fig. 2b** die Verteilung Magnetisierungsrichtungen in einem "klassischen" 2D-Halbach-Ring nach dem Stand der Technik, bei welcher die Magnetisierungsvektoren stets innerhalb der Ringebene liegen.

Erfindungsgemäß werden die Magnetsegmente 3 bei der erfindungsgemäßen Magnetanordnung so aufgebaut, dass die Magnetisierungsrichtung der einzelnen Magnetsegmente 3 der Formel

$$Mr = MCos[\alpha]Cos[\phi 0], \quad M\phi = MSin[\phi 0], \quad Mz = MCos[\phi 0]Sin[\alpha]$$

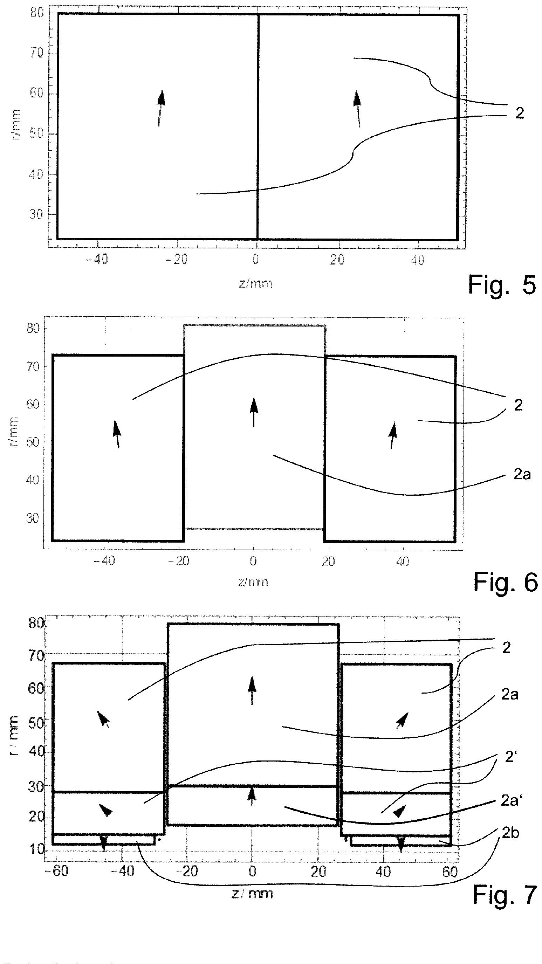

folgt, wobei Mr, M$\phi$ und Mz die Komponenten des Magnetisierungsvektors in Zylinderkoordinaten bezeichnen, M die Remanenz des im jeweiligen ringförmigen Magnetelement 2, 2' verwendeten Magnetmaterials bezeichnet, $\phi 0$ den Azimutalwinkel des Segmentmittelpunktes bezeichnet und a einen für das gesamte ringförmige Magnetelement 2,2' festen Parameter bezeichnet, nämlich den 3D-Winkel, der die Abweichung der Magnetisierungsrichtungen von denen eines ebenen Halbachringes bestimmt. **Fig. 5** zeigt ein erstes, besonders einfaches Ausführungsbeispiel:

Beispiel 1:

Die Ermittlung einer optimierten Geometrie eines erfindungsgemäßen Halbach-Magneten umfasst hier lediglich zwei ringförmige Magnetelemente 2 mit spiegelsymmetrischer Magnetisierung. Zur Illustration des erfindungsgemäßen Designprozesses soll der einfachste mögliche Fall betrachtet werden: Zwei dreidimensionale Halbachringe mit gleichem Magnetmaterial liegen symmetrisch zur Ursprungsebene. Die Innenbohrung sei fest vorgegeben.

Als freie Designvariablen bleiben dann die (halbe) Magnetlänge, der Außenradius sowie der (ebenfalls symmetrische) 3D-Winkel a übrig. Fordert man nun ein bestimmtes Zielfeld B0 (im Beispiel wurde B0=Br=1,4T gewählt bei einer Bohrung mit einem Radius von 24mm) sowie Homogenität in niedrigster Ordnung (verschwindende zweite Feldordnung B2=0), so reduzieren sich die Freiheitsgrade auf 1.

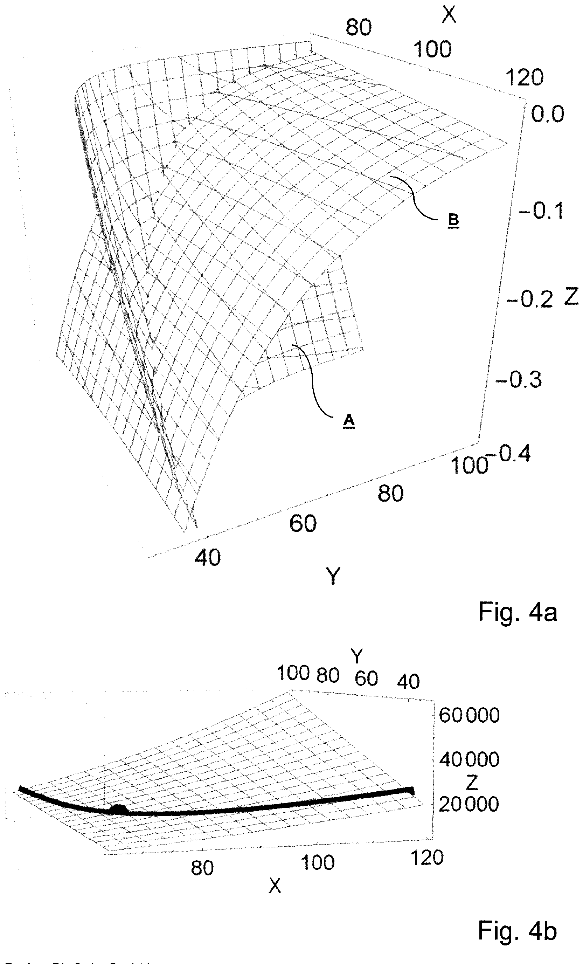

Dies wird in der Grafik von **Fig. 4a** illustriert: Die **erste Fläche A** zeigt alle Kombinationen der Designvariablen, für welche das Zielfeld B0 erreicht wird, die **zweite Fläche B** zeigt alle Kombinationen, für welche die zweite Feldordnung B2 verschwindet. Auf der X-Achse ist der Außenradius des Halbachrings in [mm] aufgetragen. Y bezeichnet die halbe Länge des Magneten in [mm]. Der 3D Winkel ist auf der Z-Achse als Radiant angegeben.

Als Schnittlinie ergibt sich diejenige Kurve, auf welcher *beide* Forderungen erfüllt sind. Zur Festlegung des aktuellen Designs wird jetzt derjenige Punkt auf der Linie gesucht, welcher das Gesamtgewicht des Magneten minimiert.

Die Grafik von **Fig. 4b** zeigt das Gewicht der Magnetanordnung als Funktion von Magnetlänge und Außenradius. Auf der X-Achse ist der Außenradius des Halbachrings in [mm] aufgetragen, Y bezeichnet wiederum die halbe Länge des Magneten in [mm] und auf der Z-Achse ist das resultierende Gewicht angegeben. Überträgt man die oben ermittelte Kurve in dieses Schaubild, so erkennt man, dass sie zu den Rändern hin ansteigt, während sie im mittleren Bereich ein Minimum annimmt. Dieser Punkt entspricht dem im Sinne der Erfindung optimierten Design.

**Fig. 6** zeigt ein weiteres, immer noch relativ einfaches Ausführungsbeispiel:

Beispiel 2:

Der Permanentmagnet in Halbachkonfiguration umfasst hier drei Ringe bei vorgegebener Remanenz M=B0=1,4T, wobei der **mittlere Ring 2a** einen 3D-Winkel von $\alpha$=0 hat. Die beiden äußeren Ringe 2 sind wiederum in der Magnetisierung spiegelsymmetrisch zueinander.

Wesentliche Randbedingungen für das Ausführungsbeispiel 2:

- B0=1.4T (60MHz), 48 mm Bohrung
- zweite und vierte Feldordnung verschwinden
- Br=1.4T (NdFeB)
- Gewicht 13kg
- $\alpha$ = 0,15 in den äußeren Ringen, ebener Halbachring in der Mitte

**Fig. 7** schließlich zeigt ein etwas komplexeres Ausführungsbeispiel:

Beispiel 3:

Der Permanentmagnet in Halbachkonfiguration umfasst hier acht Ringe bei vorgegebener Remanenz M=B0=1,9T, wobei die mittleren Ringe einen 3D-Winkel $\alpha$ = 0 haben. Die lateral äußeren Ringe 2, 2' sind paarweise jeweils in der Magnetisierungsrichtung spiegelsymmetrisch zueinander. An den sowohl radial äußersten als auch lateral mittleren Ring 2a mit einem 3D-Winkel von $\alpha$=0 schließt sich radial innen ein **weiterer lateral mittlerer Ring 2a'** mit einem 3D-Winkel von ebenfalls $\alpha$=0 an. **Die flachen, radial innersten ringförmigen Magnetelemente 2b,** die sich von innen an die **radial inneren 3D-Halbachringe 2'** anschließen, haben in diesem Beispiel eine homogene Magnetisierung mit dem 3D-Winkel $\alpha$ = $\pi$. Diese Ringe ergänzen das Gesamtmagnetfeld und führen weiterhin zu noch größerer Homogenität des erzeugten Magnetfelds.

Wesentliche Randbedingungen für das Ausführungsbeispiel 3:

- B0=1,9T (80MHz), 24mm Bohrung

- Zweite, vierte und sechste Feldordnung verschwinden

- Br=1,4T bzw. 1,3T bei radial inneren Ringen (NdFeB)

- Gewicht 14kg

- $\alpha$ = 0,62 bzw. 0,80 in den axial äußeren Ringen 2 bzw. 2', lateral homogen magnetisiert in den radial innersten Ringen 2b, ebene Halbachringe 2a, 2a' axial in der Mitte

Es ist in den Beispielen 2 und 3 deutlich erkennbar, dass mit der erfindungsgemäßen Konfiguration der Magnetringe und einem angepassten 3D-Winkel a in der Magnetisierungsrichtung Magnete mit einer großen Remanenz von bis zu 1,9T bei einem sehr niedrigen Gewicht (hier: 14kg) herstellbar sind. Vergleichbare Designs aus "klassischen" ebenen Halbachringen wiegen 14kg (Beispiel 2) und 20kg (Beispiel 3). Gleichzeitig ist der Magnet in Beispiel 3 derart ausgestaltet, dass Magnetfeld-Inhomogenitäten bis zur 6. Ordnung verschwinden, in Beispiel 2 immerhin bis zur 4. Ordnung.

**Bezugszeichenliste**

| | |
|---|---|
| 0 | Messvolumen |
| 1 | Magnetanordnung |
| 2; 2' | ringförmige Magnetelemente mit 3D-Halbach-Magnetisierung |
| 2a; 2a' | ringförmige Magnetelemente mit 2D-Halbach-Magnetisierung |
| 2b | weitere ringförmige Magnetelemente mit 2D-Halbach-Magnetisierung |
| 3 | Magnetsegmente |

**Physikalische Größen**

| | |
|---|---|
| x, y, z | kartesische Koordinaten |
| $\phi 0$ | Azimutalwinkel des Segmentmittelpunktes |
| $\alpha$ | 3D-Winkel |
| M | Remanenz |
| $\mu$ | Permeabilität |
| HcJ | Koerzitivität |
| Tk | Temperaturkoeffizienten |
| n | Ordnung der Fernfeldkoeffizienten |
| B0 | Ziel-Magnetfeld |
| A | erste Fläche |

B    zweite Fläche

**Referenzliste:**

Für die Beurteilung der Patentfähigkeit in Betracht gezogene Druckschriften

[1a] JP 2006 294851 A
[1b] US 10 018 694 B2
[2] US 2010/013473 A1
[3] US-A 4,837,542
[4] US 2015/0061680 A1

**Patentansprüche**

1. Magnetresonanz-Apparatur mit einem Permanentmagnetsystem mit einer Magnetanordnung (1) zur Erzeugung eines homogenen Magnetfeldes in einer Richtung senkrecht zu einer z-Achse in einem Messvolumen (0), wobei das Permanentmagnetsystem mindestens zwei koaxial um die z-Achse angeordnete, ringförmige Magnetelemente (2, 2') mit magnetischem Material in einer Ringebene umfasst, die in einer Halbach-Konfiguration einzelne Magnetsegmente (3) aufweisen,

wobei die Magnetisierungsrichtung von mindestens zwei ringförmigen Magnetelementen (2, 2') von der Ringebene derart abweicht, dass die zur Ringebene senkrechte Komponente mit dem Azimutalwinkel durch den Mittelpunkt des jeweiligen Magnetsegments (3) eines ringförmigen Magnetelements (2, 2') variiert, wobei ein 3D-Winkel a die Abweichung der Magnetisierungsrichtungen von denen eines ebenen Halbachringes bestimmt, und wobei die Magnetisierung jeweils zweier ringförmiger Magnetelemente (2, 2') spiegelsymmetrisch zueinander ist, wobei die Spiegelebene die zur z-Achse senkrechte zentrale x-y-Ebene ist,
wobei die ringförmigen Magnetelemente (2, 2') jeweils aus nebeneinander angeordneten Magnetsegmenten (3) aus magnetischem Material aufgebaut sind, und
wobei die Magnetisierungsrichtung der Magnetsegmente (3) bezüglich ihrer zur jeweiligen Ringebene parallelen äußeren Oberflächen jeweils verschieden ist von derjenigen ihrer beiden im ringförmigen Magnetelement (2, 2') benachbarten Magnetsegmente (3),
**dadurch gekennzeichnet, dass** die Magnetsegmente (3) so aufgebaut sind, dass die Magnetisierungsrichtung der einzelnen Magnetsegmente (3) der Formel

$$Mr=MCos[\alpha]Cos[\phi 0], \; M\phi=MSin[\phi 0], \; Mz=MCos[\phi 0]Sin[\alpha]$$

folgt, wobei Mr, $M\varphi$ und Mz die Komponenten des Magnetisierungsvektors in Zylinderkoordinaten bezeichnen, M die Remanenz des im jeweiligen ringförmigen Magnetelement (2, 2') verwendeten Magnetmaterials bezeichnet, $\phi 0$ den Azimutalwinkel durch den Mittelpunkt des jeweiligen Magnetsegments (3) bezeichnet und a einen für das gesamte ringförmige Magnetelement (2, 2') festen Parameter bezeichnet, nämlich den 3D-Winkel, der die Abweichung der Magnetisierungsrichtungen von denen eines ebenen Halbachringes bestimmt.

2. Magnetresonanz-Apparatur nach Anspruch 1, **dadurch gekennzeichnet, dass** die Magnetsegmente (3) aus einem hartmagnetischen Material mit einer hohen Remanenz M, wobei 1,5T > M > 0,7T, und mit kleiner Permeabilität $\mu$ im Bereich 1,0 < $\mu$ < 1,5, insbesondere aus NdFeB, hergestellt sind.

3. Magnetresonanz-Apparatur nach einem der vorhergehenden Ansprüche, **dadurch gekennzeichnet, dass** die in einem Bereich hoher Feldstärken angeordneten Magnetsegmente (3) aus einem hochkoerzitiven Material mit einer Koerzitivität HcJ im Bereich 2800kA/m > HcJ > 1500kA/m hergestellt sind.

4. Magnetresonanz-Apparatur nach einem der vorhergehenden Ansprüche, **dadurch gekennzeichnet, dass** die Magnetsegmente (3) aus einem Temperatur-kompensierten Permanentmagnet-Material mit einem Temperaturkoeffizienten Tk im Bereich 0%/K > Tk > -0,05%/K, insbesondere aus SmCo, hergestellt sind.

5. Magnetresonanz-Apparatur nach einem der vorhergehenden Ansprüche, **dadurch gekennzeichnet, dass** mindestens ein weiteres ringförmiges Magnetelement (2a; 2a') als ebener Halbach-Ring mit $\alpha = 0$ koaxial zu den mindestens zwei koaxial um die z-Achse angeordneten, ringförmigen Magnetelementen (2, 2') angeordnet ist.

6. Magnetresonanz-Apparatur nach einem der vorhergehenden Ansprüche, **dadurch gekennzeichnet, dass** mindestens ein weiteres ringförmiges Magnetelement (2b) als lateral homogen magnetisierter Ring mit α = π koaxial zu den mindestens zwei koaxial um die z-Achse angeordneten, ringförmigen Magnetelementen (2, 2') angeordnet ist.

7. Magnetresonanz-Apparatur nach einem der vorhergehenden Ansprüche, **dadurch gekennzeichnet, dass** die ringförmigen Magnetelemente (2, 2') so aufgebaut sind, dass Fernfeldkoeffizienten niedriger Ordnung n ≤ 6, insbesondere das Dipolmoment, verschwinden.

8. Magnetresonanz-Apparatur nach einem der vorhergehenden Ansprüche, **dadurch gekennzeichnet, dass** die ringförmigen Magnetelemente (2, 2') konzentrisch um die z-Achse angeordnet sind, und dass das radial innere ringförmige Magnetelement (2') eine höhere Koerzitivfeldstärke aufweist als die radial äußeren ringförmigen Magnetelemente (2).

9. Magnetresonanz-Apparatur nach einem der vorhergehenden Ansprüche, **dadurch gekennzeichnet, dass** die Magnetsegmente (3) jedes ringförmigen Magnetelements (2, 2') die gleiche äußere Form aufweisen.

10. Magnetresonanz-Apparatur nach einem der vorhergehenden Ansprüche, **dadurch gekennzeichnet, dass** die Magnetsegmente (3) jedes ringförmigen Magnetelements (2, 2') die Form eines trapezoidalen Prismas aufweisen.

11. Magnetresonanz-Apparatur nach einem der vorhergehenden Ansprüche, **dadurch gekennzeichnet, dass** die Magnetsegmente (3) jedes ringförmigen Magnetelements (2, 2') im montierten Zustand unmittelbar aneinander angrenzend angeordnet sind.

12. Verfahren zur Herstellung einer Magnetresonanz-Apparatur mit einem Permanentmagneten mit einer Magnetanordnung (1) nach einem der vorhergehenden Ansprüche, umfassend folgende Schritte:

a) Vorgeben eines Ziel-Magnetfeldes B0 sowie der erforderlichen Anzahl an ringförmigen Magnetelementen (2, 2') aus bekanntem Magnetmaterial und einem gewünschten Innendurchmesser einer der zentralen Bohrung;
b) Bestimmen der gewünschten Homogenität und Streufeldeigenschaften durch Nullsetzen mindestens einer Feldordnung der zentralen oder der Fernfeld-Entwicklung;
c) Bestimmen der freien Designparameter, nämlich Geometrieparameter der ringförmigen Magnetelemente (2, 2') und 3D-Winkel α der ringförmigen Magnetelemente (2, 2'), durch Optimierung des Magnetvolumens unter den Nebenbedingungen der Schritte a) und b);
d) Bestimmen des gewünschten Gewichts der Magnetanordnung als Funktion der unter Schritt c) bestimmten Designparameter;
e) Aufbau der Magnetsegmente der Magnetanordnung, so dass die Magnetisierungsrichtung der einzelnen Magnetsegmente der Formel Mr = MCos[α]Cos[Φ0], MΦ = MSin[0] Mz = MCos[Φ0]Sin[α] folgt, wobei Mr, MΦ und Mz die Komponenten des Magnetisierungsvektors in Zylinderkoordinaten bezeichnen, M die Remanenz des im jeweiligen ringförmigen Magnetelement verwendeten Magnetmaterials bezeichnet, Φ0 den Azimutalwinkel des Segmentmittelpunktes und α den für das gesamte ringförmige Magnetelement festen 3D-Winkel bezeichnet, der die Abweichung der Magnetisierungsrichtungen von denen eines ebenen Halbachringes bestimmt.

13. Verfahren nach Anspruch 12, **dadurch gekennzeichnet, dass** in Schritt c) die Berechnung der Feldordnungen und des Magnetvolumens direkt aus den Designparametern über analytische Formeln erfolgt.

14. Verfahren nach Anspruch 12 oder 13, wobei die einzelnen Magnetsegmente (3) in der definierten Magnetisierungsrichtung unter Einhaltung des 3D-Winkels a sowie des Halbachwinkels hergestellt werden, bevor sie zu ringförmigen Magnetelementen (2, 2') assembliert werden.

## Claims

1. Magnetic resonance apparatus having a permanent magnet system with a magnet arrangement (1) for generating a homogeneous magnetic field in a direction perpendicular to a z-axis in a measurement volume (0), wherein the permanent magnet system comprises at least two ring-shaped magnet elements (2, 2') containing magnetic material in a ring plane, which are arranged coaxially around the z-axis and which comprise individual magnet segments (3) arranged in a Halbach configuration,

wherein the magnetization direction of at least two ring-shaped magnet elements (2, 2') deviates from the ring plane in such a way that the component perpendicular to the ring plane varies with the azimuthal angle through the center of the respective magnet segment (3) of a ring-shaped magnet element (2, 2'), wherein a 3D angle $\alpha$ determines the deviation of the magnetization directions from those of a planar Halbach ring, and wherein the magnetization of in each case two ring-shaped magnet elements (2, 2') is mirror-symmetrical with respect to one another, wherein the mirror plane is the central x-y-plane perpendicular to the z-axis, wherein the ring-shaped magnet elements (2, 2') are constructed from magnet segments (3) arranged next to one another which are composed of magnetic material, and wherein the magnetization direction of the magnet segments (3) with respect to their outer surfaces parallel to the respective ring plane is different in each case from that of their two magnet segments (3) adjacent in the ring-shaped magnet element (2, 2'), **characterized in that** the magnet segments (3) are constructed such that the magnetization direction of the individual magnet segments (3) follows the formula

$$Mr=MCos[\alpha]Cos[\phi 0], \quad M\phi=MSin[\phi 0], \quad Mz=MCos[\phi 0]Sin[\alpha],$$

wherein Mr, M$\varphi$ and Mz denote the components of the magnetization vector in cylindrical coordinates: M denotes the remanence of the magnet material used in the respective ring-shaped magnet element (2, 2'), $\phi 0$ denotes the azimuthal angle through the center of the respective magnet segment (3), and a denotes a parameter fixed for the entire ring-shaped magnet element (2, 2'), namely the 3D angle that determines the deviation of the magnetization directions from those of a planar Halbach ring.

2. Magnetic resonance apparatus according to claim 1, **characterized in that** the magnet segments (3) are produced from a hard-magnetic material having a high remanence M, wherein 1,5 T > M > 0,7 T, and having a low permeability $\mu$ in the range of 1,0 < $\mu$ < 1,5, in particular from NdFeB.

3. Magnetic resonance apparatus according to any of the preceding claims, **characterized in that** the magnet segments (3) arranged in a region of high field strengths are produced from a high-coercivity material having a coercivity HcJ in the range of 2800 kA/m > HcJ > 1500 kA/m.

4. Magnetic resonance apparatus according to any of the preceding claims, **characterized in that** the magnet segments (3) are produced from a temperature-compensated permanent magnet material having a temperature coefficient Tk in the range of 0%/K > Tk > -0,05%/K, in particular from SmCo.

5. Magnetic resonance apparatus according to any of the preceding claims, **characterized in that** at least one further ring-shaped magnet element (2a; 2a'), as a planar Halbach ring where a = 0, is arranged coaxially with respect to the at least two ring-shaped magnet elements (2, 2') arranged coaxially around the z-axis.

6. Magnetic resonance apparatus according to any of the preceding claims, **characterized in that** at least one further ring-shaped magnet element (2b), as a laterally homogeneously magnetized ring where $\alpha = \pi$, is arranged coaxially with respect to the at least two ring-shaped magnet elements (2, 2') arranged coaxially around the z-axis.

7. Magnetic resonance apparatus according to any of the preceding claims, **characterized in that** the ring-shaped magnet elements (2, 2') are constructed such that far field coefficients of low order n $\leq$ 6, in particular the dipole moment, vanish.

8. Magnetic resonance apparatus according to any of the preceding claims, **characterized in that** the ring-shaped magnet elements (2, 2') are arranged concentrically around the z-axis, and **in that** the radially inner ring-shaped magnet element (2') has a higher coercive field strength than the radially outer ring-shaped magnet elements (2).

9. Magnetic resonance apparatus according to any of the preceding claims, **characterized in that** the magnet segments (3) of each ring-shaped magnet element (2, 2') have the same outer shape.

10. Magnetic resonance apparatus according to any of the preceding claims, **characterized in that** the magnet segments (3) of each ring-shaped magnet element (2, 2') have the shape of a trapezoidal prism.

11. Magnetic resonance apparatus according to any of the preceding claims, **characterized in that** the magnet segments (3) of each ring-shaped magnetic element (2, 2') are arranged directly adjacent to each other in the assembled state.

12. Method for producing a magnetic resonance apparatus having a permanent magnet with a magnet arrangement (1) according to any of the preceding claims, comprising the following steps:

a) predefining a target magnetic field B0 as well as the required number of ring-shaped magnet elements (2, 2') composed of known magnet material and a desired internal diameter of a central hole;
b) determining the desired homogeneity and leakage field properties by equating to zero at least one field order of the central or far field expansion;
c) determining the free design parameters, namely geometry parameters of the ring-shaped magnet elements (2, 2') and 3D angles $\alpha$ of the ring-shaped magnet elements (2, 2'), by optimizing the magnet volume under the constraints from steps a) and b);
d) determining the desired weight of the magnet arrangement as a function of the design parameters determined under step c);
e) construction of the magnet segments of the magnet arrangement such that the magnetization direction of the individual magnet segments follows the formula Mr=MCos[$\alpha$]Cos[$\phi$0], M$\phi$=MSin[$\phi$0], Mz=MCos[$\phi$0]Sin[$\alpha$], wherein Mr, M$\phi$ and Mz denote the components of the magnetization vector in cylindrical coordinates, M denotes the remanence of the magnet material used in the respective ring-shaped magnet element, $\phi$0 denotes the azimuthal angle of the center of the segment (3), and a denotes the 3D angle fixed for the entire ring-shaped magnet element that determines the deviation of the magnetization directions from those of a planar Halbach ring.

13. Method according to Claim 12, **characterized in that** in step c) the field orders and the magnet volume are calculated directly from the design parameters by way of analytical formulae.

14. Method according to Claim 12 or 13, wherein the individual magnet segments (3) are produced in the defined magnetization direction in a manner complying with the 3D angle $\alpha$ as well as the Halbach angle before they are assembled to form ring-shaped magnet elements (2, 2').

**Revendications**

1. Appareil à résonance magnétique comprenant un système d'aimants permanents comprenant un ensemble d'aimants (1) destiné à générer un champ magnétique homogène dans une direction perpendiculaire à un axe z dans un volume de mesure (0), le système d'aimants permanents comprenant au moins deux éléments magnétiques (2, 2') en forme d'anneau qui sont disposés coaxialement autour de l'axe z, qui comprennent un matériau magnétique dans un plan d'anneau et qui présentent des segments d'aimant individuels (3) dans une configuration d'Halbach,

la direction d'aimantation d'au moins deux éléments magnétiques (2, 2') en forme d'anneau s'écartant du plan de l'anneau de manière à ce que la composante perpendiculaire au plan de l'anneau varie en fonction de l'angle d'azimut passant par le centre du segment d'aimant respectif (3) d'un élément magnétique (2, 2') en forme d'anneau, un angle 3D $\alpha$ déterminant l'écart des directions d'aimantation par rapport à celles d'un anneau d'Halbach plan,
et l'aimantation de deux éléments magnétiques (2, 2') en forme d'anneau étant en symétrie de miroir l'un par rapport à l'autre, le plan du miroir étant le plan central xy perpendiculaire à l'axe z,
les éléments magnétiques (2, 2') en forme d'anneau étant construits chacun à partir de segments d'aimant (3) en matériau magnétique disposés les uns à côté des autres,
et
la direction d'aimantation des segments d'aimant (3) par rapport à leurs surfaces extérieures parallèles au plan d'anneau respectif étant différente de celle de leurs deux segments d'aimant (3) adjacents dans l'élément d'aimant (2, 2') en forme d'anneau,
**caractérisé en ce que** les segments d'aimant (3) sont construits de manière à ce que la direction d'aimantation des différents segments d'aimant (3) réponde à la formule Mr=MCos[$\alpha$]Cos[$\phi$0], M$\phi$=MSin[$\phi$0] Mz=MCos[$\phi$0]Sin[$\alpha$], Mr , M$\phi$ et Mz désignant les composantes du vecteur d'aimantation en coordonnées cylindriques, M désignant la rémanence du matériau magnétique utilisé dans l'élément magnétique respectif (2, 2') en forme d'anneau, $\phi$0 désignant l'angle d'azimut passant par le centre du segment d'aimant respectif (3)

et $\alpha$ désignant un paramètre fixe pour l'ensemble de l'élément magnétique (2, 2') en forme d'anneau, c'est-à-dire l'angle 3D qui détermine l'écart des directions d'aimantation par rapport à celles d'un anneau d'Halbach plan.

2. Appareil à résonance magnétique selon la revendication 1, **caractérisé en ce que** les segments d'aimant (3) sont fabriqués à partir d'un matériau magnétique dur à haute rémanence M, avec 1,5T > M > 0,7T, et à faible perméabilité $\mu$ dans la gamme 1,0 < $\mu$ < 1,5, notamment en NdFeB.

3. Appareil à résonance magnétique selon l'une des revendications précédentes, **caractérisé en ce que** les segments d'aimant (3) disposés dans une région de fortes intensités de champ sont fabriqués à partir d'un matériau à haute coercivité ayant une coercivité HcJ dans la gamme 2800kA/m > HcJ > 1500kA/m.

4. Appareil à résonance magnétique selon l'une des revendications précédentes, **caractérisé en ce que** les segments d'aimant (3) sont fabriqués à partir d'un matériau d'aimant permanent compensé en température ayant un coefficient de température Tk dans la gamme 0%/K > Tk > -0,05%/K, notamment en SmCo.

5. Appareil à résonance magnétique selon l'une des revendications précédentes, **caractérisé en ce qu'**au moins un autre élément magnétique (2a ; 2a') en forme d'anneau sous la forme d'un anneau d'Halbach plan avec $\alpha$ = 0 est disposé coaxial aux au moins deux éléments magnétiques (2, 2') en forme d'anneau disposés coaxialement autour de l'axe z.

6. Appareil à résonance magnétique selon l'une des revendications précédentes, **caractérisé en ce qu'**au moins un autre élément magnétique (2b) en forme d'anneau, se présentant sous la forme d'un anneau aimanté latéralement de manière homogène avec $\alpha$ = $\pi$, est disposé coaxialement aux au moins deux éléments magnétiques (2, 2') en forme d'anneau disposés coaxialement autour de l'axe z.

7. Appareil à résonance magnétique selon l'une des revendications précédentes, **caractérisé en ce que** les éléments magnétiques (2, 2') en forme d'anneau sont construits de manière à ce que les coefficients de champ lointain d'ordre inférieur n $\leq$ 6, en particulier le moment dipolaire, deviennent infiniment petits.

8. Appareil à résonance magnétique selon l'une des revendications précédentes, **caractérisé en ce que** les éléments magnétiques (2, 2') en forme d'anneau sont disposés concentriquement autour de l'axe z, et **en ce que** l'élément magnétique (2') en forme d'anneau, radialement intérieur, présente une intensité de champ coercitif supérieure à celle des éléments magnétiques (2) en forme d'anneau radialement extérieurs.

9. Appareil à résonance magnétique selon l'une des revendications précédentes, **caractérisé en ce que** les segments d'aimant (3) de chaque élément magnétique (2, 2') en forme d'anneau ont la même forme extérieure.

10. Appareil à résonance magnétique selon l'une des revendications précédentes, **caractérisé en ce que** les segments d'aimant (3) de chaque élément magnétique (2, 2') en forme d'anneau ont la forme d'un prisme trapézoïdal.

11. Appareil à résonance magnétique selon l'une des revendications précédentes, **caractérisé en ce que** les segments d'aimant (3) de chaque élément d'aimant (2, 2') en forme d'anneau sont disposés de manière directement adjacente les uns aux autres à l'état monté.

12. Procédé de fabrication d'un appareil à résonance magnétique à aimant permanent comprenant un ensemble d'aimants (1) selon l'une des revendications précédentes, ledit procédé comprenant les étapes suivantes :

a) spécifier un champ magnétique cible B0 et le nombre requis d'éléments magnétiques (2, 2') en forme d'anneau en matériau magnétique connu et d'un diamètre intérieur souhaité d'un alésage central ;
b) déterminer l'homogénéité et les propriétés de champ de dispersion souhaitées par passage à zéro d'au moins un ordre de champ du développement de champ central ou éloigné ;
c) déterminer les paramètres de conception libres, à savoir les paramètres géométriques des éléments magnétiques (2, 2') en forme d'anneau et l'angle 3D $\alpha$ des éléments magnétiques (2, 2') en forme d'anneau par optimisation du volume de l'aimant dans les conditions secondaires des étapes a) et b) ;
d) déterminer le poids souhaité de l'ensemble d'aimants en fonction des paramètres de conception déterminés à l'étape c) ;
e) construire les segments d'aimant de l'ensemble d'aimants de manière à ce que la direction d'aimantation des différents segments d'aimant réponde à la formule Mr=MCos[$\alpha$]Cos[$\phi$0], M$\phi$=MSin[$\phi$0] Mz=MCos[$\phi$0]Sin[$\alpha$],

Mr, Mɸ et Mz désignant les composantes du vecteur d'aimantation en coordonnées cylindriques, M désignant la rémanence du matériau magnétique utilisé dans l'élément magnétique respectif en forme d'anneau, ɸ0 désignant l'angle d'azimut passant par le centre du segment d'aimant respectif et α désignant l'angle 3D, fixe pour l'ensemble de l'élément magnétique en forme d'anneau, qui détermine l'écart des directions d'aimantation par rapport à celles d'un anneau d'Halbach plan.

13. Procédé selon la revendication 12, **caractérisé en ce que**, à l'étape c), le calcul des ordres de champ et du volume d'aimant est effectué directement à partir des paramètres de conception par des formules analytiques.

14. Procédé selon la revendication 12 ou 13, les différents segments d'aimant (3) étant fabriqués dans la direction d'aimantation définie tout en maintenant l'angle 3D α et l'angle d'Halbach avant d'être assemblés pour former des éléments magnétiques (2, 2') en forme d'anneau.

Fig. 1a

Fig. 1b

Fig. 2a

PRIOR ART

Fig. 2b

Fig. 3a

Fig. 3b

Fig. 4a

Fig. 4b

Fig. 5

Fig. 6

Fig. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 2006294851 A
- US 10018694 B2
- US 4837542 A
- US 20150061680 A1
- US 2010013473 A1